(19) Europäisches Patentamt
European Patent Office
Office européen des brevets

(11) **EP 3 491 400 B1**

(12) **FASCICULE DE BREVET EUROPEEN**

(45) Date de publication et mention
de la délivrance du brevet:
**13.05.2020 Bulletin 2020/20**

(21) Numéro de dépôt: **17742784.6**

(22) Date de dépôt: **28.07.2017**

(51) Int Cl.:
*G01R 27/06* (2006.01)     *G01R 31/02* (2006.01)
*G01R 31/08* (2020.01)     *G01R 27/32* (2006.01)
*H04B 3/46* (2015.01)

(86) Numéro de dépôt international:
**PCT/EP2017/069206**

(87) Numéro de publication internationale:
**WO 2018/020019 (01.02.2018 Gazette 2018/05)**

(54) **PROCÉDÉ ET SYSTÈME DE LOCALISATION DE DÉFAUTS SUR UN CÂBLE ÉLECTRIQUE**

VERFAHREN UND SYSTEM ZUM LOKALISIEREN VON DEFEKTEN AN EINEM ELEKTRISCHEN KABEL

METHOD AND SYSTEM FOR LOCATING DEFECTS ON AN ELECTRIC CABLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.07.2016 FR 1657416**

(43) Date de publication de la demande:
**05.06.2019 Bulletin 2019/23**

(73) Titulaires:
• **Electricité de France**
**75008 Paris (FR)**
• **Institut National de Recherche en Informatique et en Automatique**
**78150 Rocquencourt (FR)**

(72) Inventeurs:
• **BERRABAH, Nassif**
**77250 Moret-Sur-Loing (FR)**
• **ZHANG, Qinghua**
**35510 Cesson-Sevigne (FR)**

(74) Mandataire: **Regimbeau**
**20, rue de Chazelles**
**75847 Paris Cedex 17 (FR)**

(56) Documents cités:
**KR-B1- 100 957 812     US-A1- 2013 204 555**

• **Vladimir Dmitriev-Zdorov ET AL: "Computation of Time Domain Impedance Profile from S-Parameters: Challenges and Methods", , 31 décembre 2014 (2014-12-31), XP055357368, Extrait de l'Internet: URL:http://cdn.teledynelecroy.com/files/whitepapers/computation_of_tdr_impedance_from_sparameters.pdf [extrait le 2017-03-22]**
• **Anonymous: "IConnect and MeasureXtractor Signal Integrity TDR and S-parameter Software", , 1 janvier 2007 (2007-01-01), XP055357169, Extrait de l'Internet: URL:http://www.electrorent.com/products/search/pdf/TEK-80sspar.pdf [extrait le 2017-03-21]**
• **Anonymous: "Agilent Technologies 8510C Network Analyzer System Operating and Programming Manual", , 1 mai 2001 (2001-05-01), XP055356672, Extrait de l'Internet: URL:http://sigma.ucsd.edu/Facilities/manuals/8510C.pdf [extrait le 2017-03-20]**
• **H Tang ET AL: "AN EFFICIENT INVERSE SCATTERING ALGORITHM AND ITS APPLICATION TO LOSSY ELECTRIC TRANS-MISSION LINE SYNTHESIS", Progress In Electromagnetics Research Letters, 1 janvier 2011 (2011-01-01), pages 77-90, XP055355152, Extrait de l'Internet: URL:http://www.jpier.org/PIERL/pierl24/10.11010706.pdf [extrait le 2017-03-21]**

EP 3 491 400 B1

- HUAIBIN TANG ET AL: "An Inverse Scattering Approach to Soft Fault Diagnosis in Lossy Electric Transmission Lines", IEEE TRANSACTIONS ON ANTENNAS AND PROPAGATION, IEEE SERVICE CENTER, PISCATAWAY, NJ, US, vol. 59, no. 10, 1 octobre 2011 (2011-10-01), pages 3730-3737, XP011361253, ISSN: 0018-926X, DOI: 10.1109/TAP.2011.2163772

- QINGHUA ZHANG ET AL: "Inverse Scattering for Soft Fault Diagnosis in Electric Transmission Lines", IEEE TRANSACTIONS ON ANTENNAS AND PROPAGATION., vol. 59, no. 1, 1 janvier 2011 (2011-01-01), pages 141-148, XP055355174, US ISSN: 0018-926X, DOI: 10.1109/TAP.2010.2090462

**Description**

**DOMAINE TECHNIQUE**

La présente invention concerne le domaine de la détection de défauts dans des câbles électriques.

**ETAT DE LA TECHNIQUE**

De nombreux produits et systèmes industriels utilisent des câbles pour le transfert de données (mesures, commandes) ainsi que pour l'acheminement d'énergie électrique (alimentation de matériels, transport d'électricité). Un fonctionnement efficace et sûr de ces systèmes exige des câbles en bon état et une politique de maintenance adaptée.

Dans ce contexte, il devient nécessaire de disposer d'outils pour inspecter l'état de dégradation et/ou de vieillissement des liaisons filaires. Il s'agit de savoir détecter, localiser et identifier les défauts qui pourraient affecter les câbles.

Ces défauts peuvent intervenir sur toute la longueur du câble, on parle alors de défaut global.

Les défauts peuvent également concerner uniquement une certaine portion de la longueur d'un câble. C'est le cas des défauts dits locaux.

On distingue également les défauts selon qu'ils sont francs (circuit ouvert, court-circuit) rendant le câble inopérant, ou non-francs sans conséquence grave immédiate sur le fonctionnement du système (dégradation des conducteurs, vieillissement des isolants, géométrie du câble modifiée, etc.). Ces derniers peuvent cependant être considérés comme des signes précurseurs d'une dégradation plus sévère.

Les techniques existantes (en particulier la réflectométrie) offrent des performances satisfaisantes en termes de détection et de localisation des défauts francs.

En revanche, le diagnostic se fait plus difficile lorsqu'il s'agit de défauts non-francs. En effet, la réflectométrie standard repose sur le fait que les signaux électriques qui se propagent dans un câble sont partiellement ou totalement réfléchis lorsqu'ils rencontrent une variation de ses propriétés électriques. Dans le cas des défauts non-francs, ces réflexions peuvent être très faibles et leur détection/interprétation dans des mesures entachées de bruit rendue d'autant plus difficile (cf. [1]). De plus, l'occurrence de réflexions multiples peut compliquer davantage encore le travail de diagnostic.

Ainsi bien que les méthodes classiquement utilisées pour détecter des défauts non-francs utilisent encore des technique de réflectométrie, un inconvénient majeur de ces techniques est qu'une partie importante de l'onde n'est pas réfléchie, d'où une mauvaise détection des défauts.

Pourtant, les défauts non-francs peuvent constituer des indicateurs du vieillissement d'un câble et/ou des signes avant-coureurs de failles plus conséquentes. Il est donc souhaitable de disposer de techniques et de méthodes permettant de les détecter, de les localiser et de les caractériser. Cela permettrait de mettre en place une maintenance préventive et d'éviter les surcoûts liés à une interruption du fonctionnement suite à une panne.

Il existe des méthodes pour le diagnostic de défauts non-francs qui sont basées sur la résolution de problèmes d'optimisation, mais ces méthodes sont généralement très coûteuses en terme de calculs numériques [3, 4, 2]. Dans [5], une méthode numériquement efficace est proposée pour le diagnostic de défauts non-francs caractérisés par de faibles variations d'impédance, notamment sans discontinuité d'impédance, mais en négligeant les pertes d'énergie électrique, donc inadaptée aux défauts caractérisés par l'augmentation de la résistance des conducteurs.

Le document KR 100957812 [6] propose une méthode de détection de la localisation d'un défaut par détection de coïncidence entre des impédances mesurées à partir de deux extrémités d'un câble, sans préciser la nature des défauts. Il ne permet pas de quantifier un défaut résistif en termes de la résistance linéique R(z).

D'autres techniques sont décrites dans les documents [7] à [12] répertoriés en fin de description.

**RESUME DE L'INVENTION**

Dans le contexte de l'état de la technique exposé ci-dessus, la présente invention a pour objectif de proposer un procédé de détection, localisation et estimation de défauts non-francs résistifs dans le cadre d'un diagnostic de câbles.

Comme indiqué ci-dessus, un défaut non-franc, s'il n'empêche pas la transmission des données, constitue néanmoins un indicateur de vieillissement, et donc de dégradation du câble.

Le but précité est atteint selon l'invention grâce à un procédé de diagnostic de défauts sur un câble comportant les étapes suivantes :

- Mesure de la matrice des paramètres S du câble comprenant les paramètres S11, S12, S21 et S22 en fonction de la fréquence, typiquement avec un analyseur de réseaux (lorsque l'impédance de référence est adaptée au câble, S11 et S22 correspondent aux coefficients de réflexion aux deux extrémités, et S12 et S21 aux coefficients de transmission dans les deux directions);

- Détermination de l'impédance apparente du câble en fonction de la position z le long du câble, d'une part, $Z^l(z)$ à partir d'une extrémité du câble en connectant une charge adaptée à l'autre extrémité, et d'autre part, $Z^r(z)$ à partir de l'autre extrémité du câble, de manière similaire ;
- Détermination d'une estimation de la résistance linéique R(z) (« linéique » signifie « par unité de longueur ») du câble en fonction de la position z le long du câble à partir des valeurs d'impédance apparente $Z^l(z)$ et $Z^r(z)$ :

$$R(z) = \frac{[Z^l(z) - Z^r(z)] - [Z^l(z+dz) - Z^r(z+dz)]}{2\,dz}$$

où dz est le pas de discrétisation spatiale ;
- Détection d'un défaut sur le câble lorsque la résistance linéique R(z) estimée s'éloigne d'une valeur de référence.

Le procédé conforme l'invention se distingue notamment du document KR 100957812 par le fait que :

a) une mesure des coefficients de réflexion et effectuée,
b) une estimation de la résistance linéique R(z) est effectuée grâce à la formule indiquée ci-dessus,
c) le défaut est détecté lorsque la résistance linéique R(z) estimée s'éloigne d'une valeur de référence.

Ainsi alors qu'habituellement, les valeurs R, L, C et G caractérisant un câble (voir le modèle RLCG dans « Description détaillée de l'invention ») permettent de déterminer celles de la tension u et du courant i par simulation numérique, selon l'invention, on procède de manière inverse, c'est-à-dire que l'on estime la résistance linéique R(z) à partir de mesure des valeurs de la tension et du courant (u et i), ce qui permet de faire un diagnostic de la dégradation du câble.

En effet, si les valeurs estimées de R(z), sont différentes de celles prévues, on a alors détecté un défaut.

L'invention permet ainsi d'estimer la fonction R(z), ensuite l'interprétation du résultat permet immédiatement de détecter, localiser et quantifier un éventuel défaut.

Les algorithmes classiques d'estimation des valeurs de R, L, C et G sont généralement lents car ils sont basés sur des méthodes d'optimisation avec un grand nombre d'inconnus. De plus on cherche souvent à optimiser une fonction qui peut avoir plusieurs extrema, ce qui nécessite de l'information a priori sur la solution recherchée.

Pour pallier à cela, selon l'invention, on utilise un procédé numériquement efficace qui permet d'estimer R uniquement (i.e. les défauts résistifs).

Ceci est d'autant plus pertinent que les défauts résistifs peuvent, être graves (surchauffe du câble).

L'invention permet de voir si un défaut est affecté à R, soit quand une courbe R(z) obtenue présente un pic (= défaut local), soit en comparant R(z) à des valeurs nominales.

L'invention consiste donc à estimer R(z), ce qui permet de détecter des défauts résistifs.

L'invention concerne également un système comprenant des moyens adaptés pour la mise en œuvre du procédé précité.

PRESENTATION DES FIGURES

D'autres caractéristiques, buts et avantages de la présente invention apparaîtront à la lecture de la description détaillée qui va suivre, et au regard des dessins donnés à titre d'exemples non limitatifs et sur lesquels :

- la figure 1 représente schématiquement sous forme d'un organigramme les étapes du procédé conforme à la présente invention,
- la figure 2 illustre la représentation d'un câble par un modèle RLCG,
- la figure 3 illustre schématiquement l'effet de la résistance sur l'impédance apparente d'un câble,
- la figure 4 représente le résultat d'un test obtenu démontrant la détection, localisation et estimation d'une résistance ponctuelle insérée sur un câble, à l'aide du procédé conforme à l'invention, plus précisément la figure 4a représentant la résistance linéique R(z) en fonction de la position sur le câble et l'estimation de la résistance ponctuelle, tandis que la figure 4b montre un zoom autour du pic correspondant à la résistance insérée, et
- la figure 5 représente des résultats de simulation validant les hypothèses du procédé conforme à la présente invention, en représentant la résistance du câble en fonction de la position z sur le câble.

**DESCRIPTION DETAILLEE D'UN MODE DE REALISATION**

Le procédé de localisation et d'estimation des pertes ohmiques sur un câble conforme à la présente invention peut être utilisé pour détecter, localiser et estimer des défauts se traduisant par une résistance localement ou globalement plus importante et pouvant, de surcroît, occasionner des échauffements indésirables. L'estimation de ces pertes peut de plus être comparée à des valeurs de référence pour statuer sur l'état de vieillissement du câble inspecté.

En outre, lorsque la présence d'un défaut est détectée, le procédé proposé permet de lever l'ambiguïté quant à sa nature (résistive ou impédante). En effet un câble est caractérisé par les paramètres RLCG répartis sur toute la longueur du câble. Le procédé conforme à l'invention estime la résistance linéique R(z). Ceci permet de distinguer les défauts affectant la résistance linéique de ceux qui affectent l'impédance caractéristique.

Avant de décrire l'invention dans le détail, on va procéder à des rappels sur la théorie des lignes de transmission.

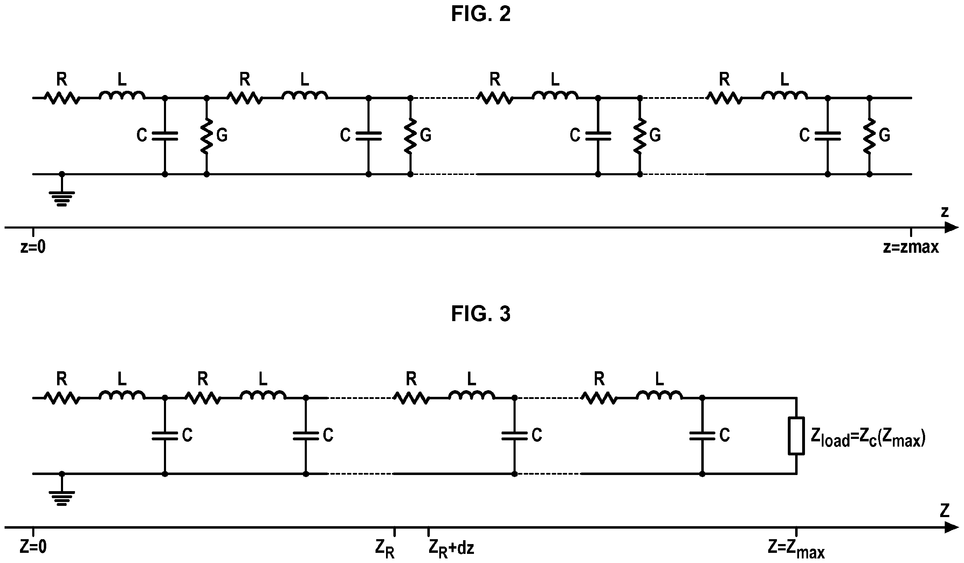

Un câble est constitué de deux conducteurs (ou plus) séparés par un isolant. Un câble est une ligne de transmission que l'on modélise habituellement (sous certaines conditions) par un modèle RLCG tel qu'illustré sur la figure 2. Ce modèle classique RLCG permet, sous certaines conditions, de caractériser la propagation d'ondes de courant et de tension. Dans ce modèle, le câble est représenté par une succession de tronçons pouvant chacun être représenté par un quadripôle RLCG comme l'illustre la figure 2. Dans ce modèle les éléments R et L sont disposés en série sur une branche située entre l'entrée et la sortie de chaque tronçon, tandis que les éléments C et G sont disposés en parallèle entre les deux ports de sortie.

On parle de modèle à constantes réparties. Les valeurs de *R, L, C et* G dépendent, en effet, de la position sur le câble :

- R(z) représente la résistance linéique des conducteurs au point d'abscisse z.
- L(z) représente l'inductance propre linéique du câble au point d'abscisse z.
- C(z) représente la capacité linéique du câble au point d'abscisse z.
- G(z) représente la conductivité linéique de l'isolant au point d'abscisse z.

Lorsque le nombre de tronçons tend vers l'infini et la longueur de chaque tronçon tend vers zéro, ce schéma tend vers la limite décrite par les équations des télégraphistes. Les ondes de tension et courant qui se propagent dans le câble sont alors régies par les équations des télégraphistes :

$$\frac{\partial u}{\partial z}(z,t) = -R(z)i(z,t) - L(z)\frac{\partial i}{\partial t}(z,t) \qquad (1a)$$

$$\frac{\partial i}{\partial z}(z,t) = -G(z)u(z,t) - C(z)\frac{\partial u}{\partial t}(z,t) \qquad (1b)$$

où u (*z,t*) et i(*z,t*) représentent respectivement la tension et le courant au point z et à l'instant t.

Ainsi, connaissant les profils R(z), L(z), C(z) et G(z) ainsi que les conditions initiales et aux limites, on peut calculer les tensions et courants dans un câble. Ceci constitue un modèle direct qui permet de déduire la propagation des ondes dans les câbles et de faire les simulations numériques.

Les paramètres R(z), L(z), C(z) et G(z) dépendent des caractéristiques physiques du câble en son point d'abscisse z (sa géométrie, les propriétés électriques des conducteurs et de l'isolant, *etc.).* Une dégradation du câble peut impacter un ou plusieurs de ces paramètres. L'estimation des paramètres RLCG à partir de quantités mesurables constitue alors une méthode de diagnostic de la dégradation. Si les équations (1) sont sous une forme adaptée à la simulation numérique du câble (calcul de la tension et du courant à partir des paramètres linéiques et des conditions initiales et aux limites), le calcul des paramètres linéiques à partir des mesures disponibles (tensions et courants aux extrémités du câble) nécessite d'inverser d'une certaine manière ces équations et constitue un problème beaucoup plus difficile. Ce dernier est habituellement appelé problème inverse, par opposition au problème direct qu'est la simulation numérique.

Le procédé de l'invention repose sur cette approche.

Plus précisément, l'invention repose sur les hypothèses et calculs suivants.

Par transformation de Fourier, les équations (1a) et (1b) sont représentées dans le domaine fréquentiel

$$\frac{\partial u}{\partial z}(z,\omega) = -R(z) - j\omega L(z)i(z,\omega) \qquad (2a)$$

$$\frac{\partial i}{\partial z}(z,\omega) = -G(z) - j\omega C(z)u(z,\omega) \qquad\qquad (2b)$$

où $\omega$ représente la pulsation du signal d'excitation.

On définit alors deux quantités (différentes en général) :

- L'impédance caractéristique du câble

$$Zc(z,\omega) = \sqrt{\frac{R(z)+j\omega L(z)}{G(z)+j\omega C(z)}}$$

- L'impédance apparente du câble

$$Z(z,\omega) = \frac{u(z,\omega)}{i(z,\omega)}$$

Par la suite, dans ces notations, la dépendance en $\omega$ sera omise pour des notations $Zc(z)$ et $Z(z)$ plus courtes.

L'effet de R(z) sur l'impédance apparente Z(z) peut être décrit par une relation simple. L'impédance apparente Z(z) dépend des composants électriques connectés au câble testé. On note $Z^l(z)$ (respectivement $Z^r(z)$) l'impédance apparente au point z lorsqu'on teste le câble en connectant un instrument à l'extrémité gauche (respectivement droite) du câble et en terminant l'extrémité droite (respectivement gauche) avec une charge adaptée. On note aussi dZ(z) la différence d'impédance entre les points d'abscisse z et z+dz dans le cas où les pertes ohmiques sont absentes. Alors, en modélisant les pertes ohmiques sur le tronçon entre les points d'abscisse z et z+dz par une résistance égale à R(z)dz, comme illustré par la figure 3, on a :

$$Z^l(z) = Z^l(z+dz) - dZ(z)+R(z)dz \qquad\qquad (3a)$$

$$Z^r(z) = Z^r(z+dz) - dZ(z)-R(z)dz \qquad\qquad (3b)$$

et on en déduit

$$R(z) = \frac{[Z^l(z) - Z^r(z)] - [Z^l(z+dz) - Z^r(z+dz)]}{2dz}$$

En pratique, au lieu d'effectuer deux mesures en connectant d'abord une charge adaptée à droite puis une autre à gauche, typiquement on connecte les deux extrémités d'un câble aux deux ports d'un analyseur de réseaux pour obtenir en une seule fois la matrice des paramètres S permettant de déterminer les impédances apparentes $Z^l(z)$ et $Z^r(z)$, et d'appliquer la méthode décrite.

En d'autres termes, l'invention comprend les étapes qui consistent à :

1. Mesurer la matrice des paramètres S d'un câble en connectant ses deux extrémités aux deux ports d'un analyseur de réseaux;.
2. Déterminer les impédances apparentes $Z^l(z)$ et $Z^r(z)$ (une méthode permettant de réaliser cette étape sera présentée plus loin à titre d'exemple);
3. puis estimer R(z):

$$R(z) = \frac{[Z^l(z) - Z^r(z)] - [Z^l(z+dz) - Z^r(z+dz)]}{2dz} \qquad\qquad (5)$$

4. Détecter d'un défaut lorsque la résistance linéique R(z) estimée s'éloigne d'une valeur de référence.

EP 3 491 400 B1

La détermination des impédances apparentes $Z^l(z)$ et $Z^r(z)$ à l'étape 2 de l'invention peut se réaliser par toute méthode disponible. A titre d'exemple, nous présentons ici une méthode numériquement efficace basée sur la théorie « inverse scattering », à l'origine destinée à l'estimation de l'impédance caractéristique d'un câble sans pertes, comme décrite dans le document [5] « Qinghua Zhang, Michel Sorine, and Mehdi Admane. Inverse scattering for soft fault diagnosis in electric transmission lines. IEEE Transactions on Antennas and Propagation, 59(1):141-148, 2011 ».
Le processus décrit dans [5] vise à obtenir l'impédance caractéristique du câble sans pertes

$$Z_0(z) = \sqrt{\frac{L(z)}{C(z)}}$$

à partir du coefficient de réflexion $r(\omega)$, qui est égal à S11 ou à S22 de la matrice des paramètres S, suivant que l'on choisit l'une ou l'autre extrémité du câble comme l'origine de l'abscisse z. Il comporte les étapes suivantes :

1) Un changement de variable est d'abord effectué:

$$x(z) = \int_0^z \sqrt{L(s)C(s)}\, ds$$

2) on calcule la transformée de Fourier inverse du coefficient de réflexion

$$\rho(x) = \frac{1}{2\pi} \int_{-\infty}^{+\infty} r(\omega)\exp(j\omega x)\, d\omega$$

3) puis les équations intégrales de Gel'fand-Levitan-Marchenko sont résolues pour les noyaux $A_1(x,y)$ et A2(x,y) :

$$A_1(x,y) + \int_{-y}^{x} A_2(x,s)\rho(y+s)\, ds = 0$$

$$A_2(x,y) + \rho(x+y) + \int_{-y}^{x} A_1(x,s)\rho(y+s)\, ds = 0$$

4) on calcule ensuite la fonction potentielle q(x) par

$$q(x) = 2A_2(x,x)$$

5) puis on calcule $Z_0(x)$ :

$$Z_0(x)\exp\left(-2\int_0^x q(s)\, ds\right)$$

Dans la présente invention, ce processus est détourné pour estimer les impédances apparentes $Z^l(z)$ et $Z^r(z)$ de la manière suivante :

- Sous l'hypothèse de défauts non francs ou de l'absence de tout défaut, les ondes réfléchies sont peu présentes dans le câble. Dans ce cas, l'impédance caractéristique $Z_0(x)$ calculée à partir de S11 suivant le processus décrit ci-dessus est approximativement égale à $Z^l(x)$, même en présence de pertes ohmiques sur le câble. De même, l'impédance caractéristique $Z_0(x)$ calculée à partir de S22 est approximativement égale à $Z^r(x)$.
- La longueur électrique du câble (homogène à une durée, correspondant au temps de prorogation d'une onde d'une extrémité à l'autre du câble) est utilisée pour faire correspondre $Z^l(x)$ et $Z^r(x)$ correctement afin d'estimer R(z). En pratique, on peut par exemple estimer cette distance électrique en utilisant le coefficient $S_{12}$ (coefficient de trans-

7

mission de la matrice des paramètres S) du câble. Dans le domaine temporel, il est nul jusqu'à la réception des premiers signaux à un instant qui correspond à la distance électrique.

- la vitesse de propagation des ondes dans le câble (ou la longueur physique du câble) est utilisée pour convertir $Z^l(x)$ et $Z^r(x)$ en $Z^l(z)$ et $Z^r(z)$.

D'autres méthodes peuvent être utilisées dans le cadre de la présente invention pour opérer le processus d'estimation précité. A titre d'exemple non limitatif on citera celle décrite dans les pages 56 à 59 de la thèse « Développement d'une nouvelle méthode de détermination des profils de teneur en eau dans les sols par inversion d'un signal TDR » Luiz Antonio PEREIRA DOS SANTOS, 20 Novembre 1997 - Université Joseph Fourier - Grenoble I.

## RESULTATS

Les inventeurs ont réalisé des tests dont les résultats vont maintenant être présentés.

D'abord un cas particulier : une résistance ponctuelle placée sur l'âme d'un câble coaxial.

Ce cas particulier est choisi pour montrer expérimentalement l'efficacité du procédé car il est facile à mettre en œuvre. En effet, la création de manière contrôlée, de défauts répartis est plus difficile expérimentalement.

Pour cette raison le second résultat qui sera présenté par la suite sera basé sur des mesures simulées. Il mettra en évidence l'intérêt du procédé pour les défauts répartis (non ponctuels).

Le procédé est testé en laboratoire de la manière suivante :

- On insère une résistance ponctuelle sur l'âme d'un câble.
- La présence de la résistance ponctuelle se traduit par un pic sur le profil la résistance linéique R(z), décrit mathématiquement par une fonction de Dirac. En pratique, les mesures sont faites avec un spectre fini, on a alors un effet d' « étalement » de la fonction de Dirac. La valeur de la résistance ponctuelle est estimée en intégrant l'estimation de R(z) sur un voisinage de la position estimée du défaut.

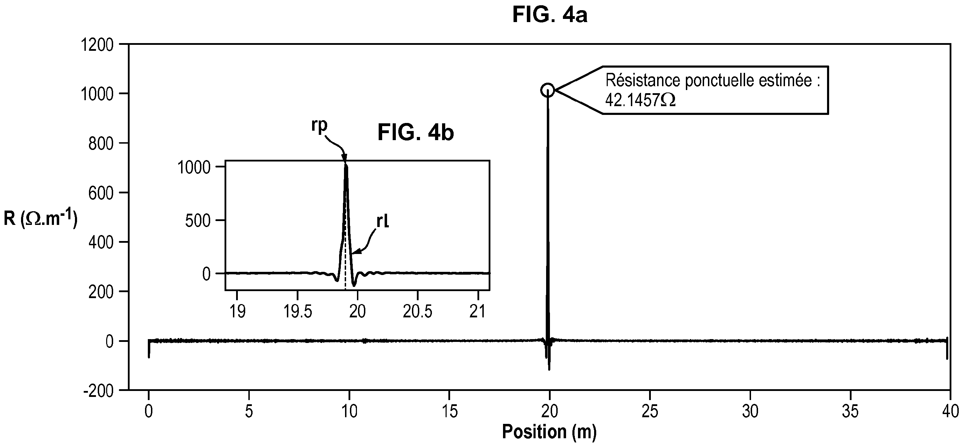

Dans l'expérience réalisée sur un câble coaxial de 40m, avec une résistance de 49.7 $\Omega$ (mesurée avec un multimètre Fluke 4485 A) insérée à 20m d'une extrémité, l'estimation obtenue est proche de la réalité (42.7 $\Omega$). La figure 4a représente la résistance linéique estimée en fonction de la position sur le câble (r/) et l'estimation de la résistance ponctuelle (rp) est obtenue par l'intégrale du pic. La figure 4b représente un zoom autour du pic.

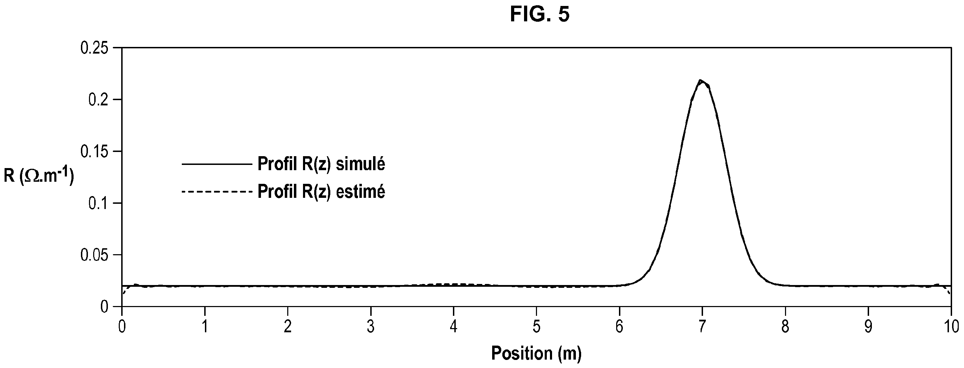

Pour illustrer l'intérêt du procédé selon l'invention dans la détection et l'estimation d'un défaut non ponctuel, les inventeurs ont également effectué une simulation numérique. Pour cela les équations (2) sont utilisées pour calculer les paramètres S d'un câble virtuel dont on donne les caractéristiques (impédance et résistance) sur la figure 5. Le procédé est appliqué et les résultats sont affichés sur la même figure 5.

On constate que la variation sur la résistance est localisée et estimée avec une très bonne précision. De plus, la variation d'impédance caractéristique du câble n'empêche pas la bonne estimation de R(z). Le procédé est donc robuste aux variations modérées de l'impédance caractéristique.

Les résultats de simulation obtenus confirment donc l'efficacité du procédé proposé selon l'invention.

Le procédé conforme à l'invention décrit ci-dessus permet de détecter et de localiser des pertes ohmiques dans un câble ainsi que d'en estimer l'ampleur. Un tel diagnostic présente un intérêt important pour tous les produits et systèmes industriels possédant des liaisons câblées (aéronautique, énergie, ferroviaire, télécom, etc.). Au-delà du diagnostic, ce procédé permet de mieux anticiper les avaries et donc d'optimiser les opérations de maintenance préventive.

De plus, ce procédé permet de distinguer les défauts résistifs (variations de R(z)) des défauts impédants (variations de $Z_c(z)$).

Contrairement aux méthodes utilisant des techniques d'optimisation [3, 4], le procédé de l'invention ne nécessite pas d'information a priori sur R(z) et son exécution numérique est très rapide (de l'ordre d'une minute sur un PC portable).

Ainsi, le procédé de l'invention constitue une avancée en matière de détection des défauts non-francs. Il peut être utilisé par exemple pour :

- la détection de jonctions défectueuses (susceptibles de chauffer excessivement).
- le suivi de vieillissement d'une jonction.
- la maintenance préventive (avant l'occurrence de défauts francs), dans une centrale de production d'électricité par exemple.
- la détection de conducteurs endommagés (par exemple lors de travaux du fait de conditions sévères d'exploitation).

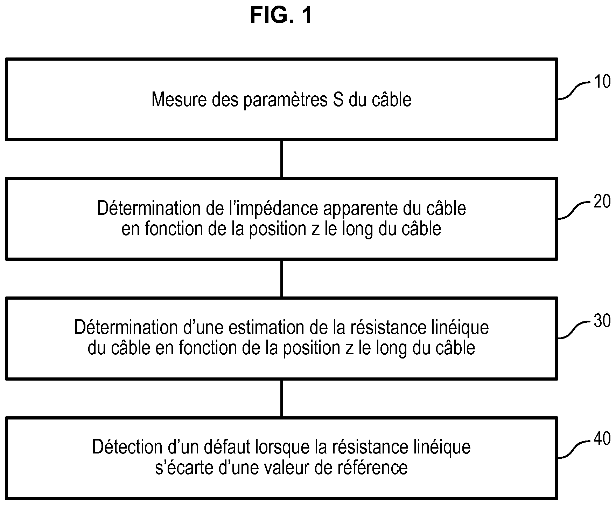

Ainsi pour l'essentiel, le procédé conforme à la présente invention comprend comme illustré sur la figure 1, les étapes suivantes :

- une étape 10 de mesure des paramètres S du câble ;
- une étape 20 de détermination de l'impédance apparente du câble en fonction de la position z le long du câble, d'une part, $Z^l(z)$ à partir d'une extrémité du câble, et d'autre part, $Z^r(z)$ à partir de l'autre extrémité du câble;
- une étape 30 de détermination d'une estimation de la résistance linéique R(z) du câble en fonction de la position z le long du câble

$$R(z) = \frac{[Z^l(z) - Z^r(z)] - [Z^l(z+dz) - Z^r(z+dz)]}{2dz}$$

- une étape 40 de détection d'un défaut sur un câble lorsque la résistance linéique R(z) estimée s'éloigne d'une valeur de référence.

Bien entendu, la présente invention n'est pas limitée au mode de réalisation précédemment décrit, mais s'étend à toute variante conforme à son esprit.

Il ressort de la description qui précède que le procédé conforme à la présente invention permet les résultats suivants et offre les avantages suivants :

- détection localisation et estimation de défauts non-francs dans un câble
- permet de distinguer les défauts résistifs des défauts impédants
- calcul numérique très rapide
- pas besoin d'information a priori sur R(z)
- détection de jonctions défectueuses (susceptible de chauffer excessivement)
- suivi de vieillissement d'une jonction
- utile dans le cadre d'un plan de maintenance préventive (avant l'occurrence de défauts francs)
- détection de conducteurs endommagés (corrosion, brins cassés, etc).

Il convient de souligner que l'invention permet d'estimer un paramètre spatialement réparti (R(z) en fonction de toute position z le long du câble), alors que la plupart des méthodes connues estiment des paramètres dont chacun est représenté par une seule valeur pour toute la longueur d'un câble, beaucoup moins riche en information, notamment ne permettant pas de localiser les défauts détectés.

Par ailleurs, le peu de publications existantes sur l'estimation de paramètres répartis le long du câble sont basées sur une discrétisation grossière du câble, peu précise et très coûteuse en temps de calcul (typiquement des heures ou des journées de calcul pour un diagnostic). Le procédé de l'invention permet une discrétisation très fine du câble (des milliers de points) et un calcul très rapide (de l'ordre d'une minute).

Selon d'autres caractéristiques avantageuses de l'invention :

- les coefficients de réflexion du câble aux deux extrémités du câble sont obtenus en connectant successivement une charge adaptée respectivement à chaque extrémité du câble,
- les coefficients de réflexion S11, S22 du câble sont obtenus sur une bande de fréquence et avec un pas de fréquence df constant.

Il ressort de ce qui précède que l'invention concerne une méthode rapide pour calculer le profil de la résistance linéique d'un câble électrique, dans le but de détecter, localiser et quantifier des défauts résistifs francs ou non francs.

L'invention permet un procédé qui présente les avantages et caractéristiques suivants :

- Rapide. A partir d'un enregistrement de données de réflectométrie spectrales, le calcul par la méthode de l'invention s'effectue en plusieurs secondes, contrairement aux méthodes basées sur un model-data fitting dont le calcul s'effectue typiquement en plusieurs heures.
- Profil. Le résultat du calcul est un profil de paramètre physique (résistance linéique), bien plus riche que la détection et la localisation de discontinuités dans le câble.
- Résistance linéique. La méthode selon l'invention se focalise sur la résistance linéique R(z) (résistance par unité de longueur, un paramètre réparti pouvant varier suivant la position z le long du câble), qui caractérise la transformation de l'énergie électrique en chaleur. Il est important de détecter, localiser et quantifier les surchauffes (excès de chaleur) qui résultent des augmentations anormales de R(z) plus ou moins localisés. Il est assez facile d'évaluer la résistance totale d'un câble, mais beaucoup plus difficile de calculer le profil de la résistance linéique R(z) tout le long du câble. A la connaissance des inventeurs, cette méthode est la seule qui permet de calculer efficacement ce profil.

- Quantifier. Le calcul de la résistance linéique R(z) permet de quantifier les défauts résistifs, alors que la plupart des méthodes antérieurement connues détectent les discontinuités d'impédance, ce qui ne permet pas de quantifier les défauts résistifs.
- Défauts résistifs. Il s'agit d'augmentations plus ou moins localisées de la résistance linéique R(z), conduisant à des pertes d'énergie électrique (autrement dit, transformation de l'énergie électrique en chaleur) avec des zones de surchauffe éventuellement dangereuses. La plupart des méthodes existantes détectent les discontinuités d'impédance, qui n'entrainent pas de pertes d'énergie.
- Défauts non francs. Contrairement aux défauts francs qui correspondent à des discontinuités sévères des propriétés d'un câble, les défauts non francs se traduisent par de faibles variations de ces propriétés, souvent sans discontinuités. La méthode selon l'invention qui calcule le profil de la résistance linéique s'applique indifféremment dans les deux cas (défauts francs et non francs), alors que la plupart des méthodes antérieurement connues sont basées sur la détection de discontinuités et se limitent donc aux défauts francs.

**REFERENCES**

[1] Lance Allen Griffits, Rohit Parakh, Cynthia Furse, and Britany Baker. The invisible fray : a critical analysis of the use of reflectometry for fray location, 2006.

[2] Martin Norgren and Sailing He. An optimization approach to the frequency-domain inverse problem for a nonuniform LCRG transmission line. IEEE Transactions On Microwave Theory And Techniques, 44(8):1503-1507,1996.

[3] Stefan Schuet. Wiring diagnostics Via l1-Regularized Least Squares. IEEE Sensors Journal, 10(7): 1218-1225, 2010.

[4] Stefan Schuet, Dogan Timuçin, and Kevin Wheeler. A model-based probabilistic inversion framework for characterizing wire fault détection using TDR. IEEE Transactions on Instrumentation and Measurement, 60(5):1654-1663, 2011.

[5] Qinghua Zhang, Michel Sorine, and Mehdi Admane. Inverse scattering for soft fault diagnosis in electric transmission lines. IEEE Transactions on Antennas and Propagation, 59(1):141-148, 2011.

[6] KR 100 957 812 (HOKMAH ENGINEERING CO LTD [KR] 13 mai 2010.

[7] US 2013/204555 (SCHEUSCHNER SVEN [DE] ET AL) 8 août 2013.

[8] Vladimir Dmitriev-Zdorov ET AL : « Computation of Time Domain Impendance Profile from S-Parameters : Challenges and Methods », 31 décembre 2014.

[9] Anonymous "IConnect and MeasureXtractor Signal Integrity TDR and S-parameter Solftware", 1 janvier 2007.

[10] Anonymous : "Agilent Technologies 8510C Network Analyzer System Operating and Programming Manual", 1 mai 2001.

[11] H Tang ET AL "AN EFFICIENT INVERSE SCATTERING ALGORITHM AND ITS APPLICATION TO LOSSY ELECTRIC TRANS- MISSIN LINE SYNTHESIS", Progress In Electromagnetic Research Letters, 1 janvier 2011.

[12] HUAIBIN TANG ET AL : "An Inverse Scattering Approach to Soft Fault Diagnosis in Lossy Electric Transmission Lines", IEEE TRANSACTIONS ON ANTENNAS AND PROPAGATION, IEEE SERVICE CENTER, PISCATAWAY, NJ, US, vol. 59, n° 10, 1 octobre 2011

Le document [7], présente une méthode pour localiser des défauts dans un câble. Un défaut (« cable fault ») est défini comme « all faults of the cable that would lead to unacceptable performance ». Sans distinction entre les différentes natures de défauts, cette méthode ne permet pas de les quantifier, mais seulement les localiser. Ce document mentionne l'exemple de défaut d'isolant provoquant des arcs électriques, qui n'est pas un défaut résistif. En tout cas cette méthode ne permet pas de quantifier un défaut résistif, donc elle ne permet pas de détecter, localiser et quantifier les surchauffes qui résultent de pertes d'énergie. La figure 1 correspond à un modèle mathématique de câbles qui contient des paramètres dont la résistance R, mais ce document ne propose pas de solution pour calculer R(z), ce qui nécessiterait de résoudre un problème inverse mathématiquement non trivial, contrairement à l'invention.

Le document [8] présente une méthode pour calculer l'impédance caractéristique, qui n'est pas la résistance linéique R(z). Notamment, une augmentation de l'impédance n'implique pas de pertes d'énergie, alors qu'une augmentation de R(z) est proportionnelle aux pertes d'énergies dites « ohmiques ». Cette méthode ne permet pas de quantifier un défaut résistif et les surchauffes éventuelles.

Le document [9] présente un dispositif pour mesurer des paramètres de connexions, mais il ne propose pas de mesure de la résistance linéique R(z), ni d'aucun paramètre équivalent. Il ne permet pas de quantifier un défaut résistif.

Le document [10] concerne un manuel d'utilisateurs qui mentionne des discontinuités en R, L ou C, mais la méthode ne fait pas de distinction entre ces 3 cas possibles, et donc ne permet pas de quantifier les pertes résistives, ni de détecter des défauts qui n'entrainent pas de discontinuité (défaut non francs).

Le document [11] étudie l'application de la théorie de l'inverse scattering à la synthèse de lignes de transmission.

Le document [12] étudie la théorie de l'inverse scattering pour résoudre un problème inverse de la ligne de transmission électrique. La solution étant mathématiquement instable, cette méthode n'est pas applicable en pratique. La méthode dans l'invention représente une avancée importante par rapport à cet article, avec un algorithme dont la stabilité a été confirmée par des expérimentations.

**Revendications**

1. Procédé de détection et de localisation de défauts sur un câble comportant les étapes suivantes :

   - Mesure des paramètres S du câble ;
   - Détermination de l'impédance apparente du câble en fonction de la position z le long du câble, d'une part, à partir d'une extrémité du câble $Z^l(z)$, et d'autre part, à partir de l'autre extrémité du câble $Z^r(z)$ ;
   - Détermination d'une estimation de la résistance linéique R(z) du câble en fonction de la position z le long du câble :

$$R(z) = \frac{[Z^l(z) - Z^r(z)] - [Z^l(z+dz) - Z^r(z+dz)]}{2dz}$$

   - Détection d'un défaut sur un câble lorsque la résistance linéique R(z) estimée s'éloigne d'une valeur de référence.

2. Procédé selon la revendication 1, **caractérisé par le fait que** l'impédance caractéristique du câble est estimée, assimilée à l'impédance apparente par approximation, par mise en œuvre d'étapes consistant à procéder à une transformée de Fourier inverse des données de coefficient de réflexion obtenues pour les deux extrémités du câble, puis à résoudre les équations intégrales de Gel'fand-Levitan-Marchenko.

3. Procédé selon l'une des revendications 1 ou 2, **caractérisé par le fait que** l'impédance caractéristique du câble est estimée, assimilée à l'impédance apparenté par approximation, par mise en œuvre du processus comprenant les étapes qui consistent à :

   . obtenir la Transformée de Fourier inverse des coefficients de réflexion,
   . résoudre les équations intégrales de Gel'fand-Levitan-Marchenko, puis
   . calculer une fonction potentielle et l'inverser pour obtenir l'impédance caractéristique.

4. Procédé selon l'une des revendications 1 à 3, **caractérisé par le fait que** les coefficients de réflexion du câble aux deux extrémités du câble sont obtenus en connectant successivement une charge adaptée respectivement à chaque extrémité du câble.

5. Procédé selon l'une des revendications 1 à 3, **caractérisé par le fait que** les coefficients de réflexion du câble aux deux extrémités du câble sont obtenus en connectant les deux extrémités du câble à deux ports respectifs d'un analyseur.

6. Procédé selon l'une des revendications 1 à 5, **caractérisé par le fait que** les coefficients de réflexion (S11, S22) du câble sont obtenus sur une bande de fréquence et avec un pas de fréquence df constant.

7. Système de détection et de localisation de défauts sur un câble, **caractérisé en ce qu'**il comprend:

   - des moyens de mesure du coefficient de réflexion du câble aux deux extrémités du câble ;
   - des moyens de détermination de l'impédance apparente du câble en fonction de la position z le long du câble, d'une part, à partir d'une extrémité du câble $Z^l(z)$, et d'autre part, à partir de l'autre extrémité du câble $Z^r(z)$ ;
   - des moyens de détermination d'une estimation de la résistance linéique R(z) du câble en fonction de la position z le long du câble à partir des valeurs d'impédance apparente $Z^l(z)$ et $Z^r(z)$ :

$$R(z) = \frac{[Z^l(z) - Z^r(z)] - [Z^l(z+dz) - Z^r(z+dz)]}{2\,dz}$$

- des moyens de détection d'un défaut sur un câble lorsque la résistance linéique R(z) estimée s'éloigne d'une valeur de référence.

**Patentansprüche**

1. Verfahren zum Ermitteln und Lokalisieren von Defekten an einem Kabel, umfassend die folgenden Schritte:

   - Messen der Parameter S des Kabels;
   - Ermitteln der scheinbaren Impedanz des Kabels in Abhängigkeit von der Position z entlang des Kabels zum einen ab einem Ende des Kabels $Z^l(z)$ und zum anderen ab dem anderen Ende des Kabels $Z^r(z)$;
   - Ermitteln einer Schätzung des Linearwiderstands R(z) des Kabels in Abhängigkeit von der Position z entlang des Kabels:

$$R(z) = \frac{[Z^l(z) - Z^r(z)] - [Z^l(z+dz) - Z^r(z+dz)]}{2\,dz}$$

   - Ermitteln eines Defekts an einem Kabel, wenn sich der geschätzte Linearwiderstand R(z) von einem Referenzwert entfernt.

2. Verfahren nach Anspruch 1, **dadurch gekennzeichnet, dass** die charakteristische Impedanz des Kabels, angelehnt an die scheinbare Impedanz durch Schätzung, durch die Durchführung von Schritten geschätzt wird, die darin bestehen, eine umgekehrte Fourier-Transformation der für die beiden Endes des Kabels erhaltenen Reflexionskoeffizientdaten durchzuführen, dann die Gel'fand-Levitan-Marchenko-Integralgleichungen zu lösen.

3. Verfahren nach einem der Ansprüche 1 oder 2, **dadurch gekennzeichnet, dass** die charakteristische Impedanz des Kabels, angelehnt an die scheinbare Impedanz durch Schätzung, durch die Durchführung von Schritten geschätzt wird, die darin bestehen:

   • die umgekehrte Fourier-Transformation der Reflexionskoeffizienten zu erhalten,
   • die Gel'fand-Levitan-Marchenko-Integralgleichungen zu lösen, dann
   • eine potentielle Funktion zu berechnen und umzukehren, um die charakteristische Impedanz zu erhalten.

4. Verfahren nach einem der Ansprüche 1 bis 3, **dadurch gekennzeichnet, dass** die Reflexionskoeffizienten des Kabels an beiden Enden des Kabels durch aufeinanderfolgendes Anschließen einer geeigneten Last an jeweils jedes Ende des Kabels erhalten werden.

5. Verfahren nach einem der Ansprüche 1 bis 3, **dadurch gekennzeichnet, dass** die Reflexionskoeffizienten des Kabels an beiden Enden des Kabels durch Anschließen der beiden Enden des Kabels an zwei jeweilige Ports eines Analysierers erhalten werden.

6. Verfahren nach einem der Ansprüche 1 bis 5, **dadurch gekennzeichnet, dass** die Reflexionskoeffizienten (S11, S22) des Kabels auf einem Frequenzband und mit einem konstanten Frequenzschritt df erhalten werden.

7. System zum Ermitteln und Lokalisieren von Defekten an einem Kabel, **dadurch gekennzeichnet, dass** es umfasst:

   - Mittel zum Messen des Reflexionskoeffizienten des Kabels an beiden Enden des Kabels;
   - Mittel zum Ermitteln der scheinbaren Impedanz des Kabels in Abhängigkeit von der Position z entlang des Kabels zum einen ab einem Ende des Kabels $Z^l(z)$ und zum anderen ab dem anderen Ende des Kabels $Z^r(z)$;
   - Mittel zum Ermitteln einer Schätzung des Linearwiderstands R(z) des Kabels in Abhängigkeit von der Position z entlang des Kabels aus den scheinbaren Impedanzwerten $Z^1(z)$ und $Z^r(z)$ :

$$R(z) = \frac{[Z^l(z) - Z^r(z)] - [Z^l(z+dz) - Z^r(z+dz)]}{2\,dz}$$

- Mittel zum Ermitteln eines Defekts an einem Kabel, wenn sich der geschätzte Linearwiderstand R(z) von einem Referenzwert entfernt.

**Claims**

1. A method for detecting and locating defects on a cable comprising the following steps:

   - Measuring the parameters S of the cable;
   - Determining the apparent impedance of the cable as a function of the position z along the cable, both from one end of the cable $Z^l(z)$, and also from the other end of the cable $Z^r(z)$;
   - Determining an estimation of the linear resistance R(z) of the cable as a function of the position z along the cable:

$$R(z) = \frac{[Z^l(z) - Z^r(z)] - [Z^l(z+dz) - Z^r(z+dz)]}{2\,dz}$$

   - Detecting a defect on a cable when the estimated linear resistance R(z) moves away from a reference value.

2. The method according to claim 1, **characterized in that** the characteristic impedance of the cable is estimated, assimilated into the apparent impedance by approximation, by conducting steps consisting of executing an inverse Fourier transform of reflection coefficient data obtained for both ends of the cable, then resolving the integral Gel'fand-Levitan-Marchenko equations.

3. The method according to any one of claims 1 or 2, **characterized in that** the characteristic impedance of the cable is estimated, assimilated into the impedance related by approximation, by executing the process comprising the steps consisting of:

   . obtaining the inverse Fourier Transform of the reflection coefficients,
   . resolving the integral Gel'fand-Levitan-Marchenko equations, then
   . calculating a potential function and reversing it to obtain the characteristic impedance.

4. The method according to any one of claims 1 to 3, **characterized in that** the reflection coefficients of the cable at both ends of the cable are obtained by connecting successively a charge adapted respectively to each end of the cable.

5. The method according to any one of claims 1 to 3, **characterized in that** the reflection coefficients of the cable at both ends of the cable are obtained by connecting the two ends of the cable to two respective ports of an analyzer.

6. The method according to any one of claims 1 to 5, **characterized in that** the reflection coefficients (S11, S22) of the cable are obtained on a frequency band and with a constant frequency pitch df.

7. A system for detecting and locating defects on a cable, **characterized in that** it comprises:

   - measuring means of the reflection coefficient of the cable at both ends of the cable;
   - determination means of the apparent impedance of the cable as a function of the position z along the cable, both from one end of the cable $Z^l(z)$ and also from the other end of the cable $Z^r(z)$;
   - determination means of an estimation of the linear resistance R(z) of the cable as a function of the position z along the cable from the values of apparent impedance $Z^l(z)$ and $Z^r(z)$.

$$R(z) = \frac{[Z^l(z) - Z^r(z)] - [Z^l(z+dz) - Z^r(z+dz)]}{2\,dz}$$

- detection means of a defect on a cable when the estimated linear resistance R(z) moves away from a reference value.

**FIG. 1**

| Mesure des paramètres S du câble | — 10 |

| Détermination de l'impédance apparente du câble en fonction de la position z le long du câble | — 20 |

| Détermination d'une estimation de la résistance linéique du câble en fonction de la position z le long du câble | — 30 |

| Détection d'un défaut lorsque la résistance linéique s'écarte d'une valeur de référence | — 40 |

# FIG. 2

# FIG. 3

EP 3 491 400 B1

FIG. 4a

FIG. 4b

Résistance ponctuelle estimée : 42.1457Ω

EP 3 491 400 B1

FIG. 5

EP 3 491 400 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- KR 100957812

- US 2013204555 A, SCHEUSCHNER SVEN

**Littérature non-brevet citée dans la description**

- **QINGHUA ZHANG ; MICHEL SORINE ; MEHDI AD-MANE.** Inverse scattering for soft fault diagnosis in electric transmission lines. *IEEE Transactions on Antennas and Propagation,* 2011, vol. 59 (1), 141-148
- **LUIZ ANTONIO PEREIRA DOS SANTOS.** Développement d'une nouvelle méthode de détermination des profils de teneur en eau dans les sols par inversion d'un signal TDR. Université Joseph Fourier - Grenoble I, 20 Novembre 1997, 56-59
- **LANCE ALLEN GRIFFITS ; ROHIT PARAKH ; CYNTHIA FURSE ; BRITANY BAKER.** *The invisible fray : a critical analysis of the use of reflectometry for fray location,* 2006
- **MARTIN NORGREN ; SAILING HE.** An optimization approach to the frequency-domain inverse problem for a nonuniform LCRG transmission line. *IEEE Transactions On Microwave Theory And Techniques,* 1996, vol. 44 (8), 1503-1507
- **STEFAN SCHUET.** Wiring diagnostics Via l1-Regularized Least Squares. *IEEE Sensors Journal,* 2010, vol. 10 (7), 1218-1225

- **STEFAN SCHUET ; DOGAN TIMUÇIN ; KEVIN WHEELER.** A model-based probabilistic inversion framework for characterizing wire fault détection using TDR. *IEEE Transactions on Instrumentation and Measurement,* 2011, vol. 60 (5), 1654-1663
- **VLADIMIR DMITRIEV-ZDOROV et al.** *Computation of Time Domain Impendance Profile from S-Parameters : Challenges and Methods,* 31 Décembre 2014
- **ANONYMOUS.** *IConnect and MeasureXtractor Signal Integrity TDR and S-parameter Solftware,* 01 Janvier 2007
- **ANONYMOUS.** Agilent Technologies 8510C Network Analyzer System Operating and Programming Manual. 01 Mai 2001
- **H TANG et al.** AN EFFICIENT INVERSE SCATTERING ALGORITHM AND ITS APPLICATION TO LOSSY ELECTRIC TRANS- MISSIN LINE SYNTHESIS. *Progress In Electromagnetic Research Letters,* 01 Janvier 2011
- An Inverse Scattering Approach to Soft Fault Diagnosis in Lossy Electric Transmission Lines. **HUAIBIN TANG et al.** IEEE TRANSACTIONS ON ANTENNAS AND PROPAGATION. IEEE SERVICE CENTER, 01 Octobre 2011, vol. 59